# EUROPÄISCHE PATENTANMELDUNG

(11) **EP 1 192 999 A1**
(43) Veröffentlichungstag der Anmeldung: **03.04.2002**
(21) Anmeldenummer: 01123122.2
(22) Anmeldetag: 27.09.2001
(51) Int. Cl.: B02C 18/00, G01V 8/10

(54) **Datenshredder und Schaltungsanordnung für denselben**

(30) Priorität: 28.09.2000 DE 10047990
(71) Anmelder: Schleicher & Co. International Aktiengesellschaft, 88672 Markdorf (DE)
(72) Erfinder: Erlecke, Jens, 88364 Wolfegg (DE)
(74) Vertreter: Patentanwälte Ruff, Wilhelm, Beier, Dauster & Partner

(57) **Zusammenfassung**

Die Erfindung betrifft einen Datenshredder sowie eine Schaltungsanordnung für einen Datenshredder.
Aufgabe der Erfindung ist es daher, bei gleichzeitiger Erhöhung der Betriebssicherheit, den Energieverbauch eines Datenshredders zu reduzieren.
Gemäß der Erfindung ist eine Ansteuerschaltung (14) für den Signalgeber (17) vorgesehen, wobei durch den Signalgeber ein gepulstes Aussenden von Signalen erfolgt.

## Beschreibung

Die Erfindung betrifft einen Datenshredder sowie eine Schaltungsanordnung für einen Datenshredder.

Datenshredder sind beispielsweise in Form von Dokumentenvernichtern allgemein bekannt. Derartige Datenshredder umfassen ein elektrisch angetriebenes Schneidwerk, in dem zugeführte Dokumente durch Schneiden oder in anderer Form zerkleinert werden. Dabei wird das Dokument je nach den gewünschten Anforderungen entweder in Streifen oder aber in kurze Papierstücke (Partikel) geschnitten. Zur Zufuhr des Schneidgutes ist ein Einlaufschacht vorgesehen. Damit das Schneidwerk nicht ständig, sondern nur dann in Betrieb ist, wenn Schneidgut zugeführt wird, ist es üblich im Bereich des Einlaufschachtes eine Lichtschranke anzuordnen, wobei auf eine Zufuhr von Schneidgut geschlossen wird, wenn die Lichtschranke unterbrochen ist. Mit Unterbrechung dieser Lichtschranke wird der elektrische Antrieb des Schneidwerks eingeschalten und das Schneidwerk beginnt zu arbeiten. Üblicherweise wird dabei die Arbeit des Schneidwerkes so lange fortgesetzt, wie die Lichtschranke im Einlaufschacht unterbrochen ist.

Dabei ist es bekannt, daß nicht nur in Papierform vorliegende Dokumente mit einem Datenshredder so zerkleinert und damit unlesbar gemacht werden können, sondern bei entsprechender Ausbildung des Datenshredders auch andere Datenträger wie z.B. Disketten, Magnetbänder und Kompaktdiscs, hier insbesondere sogenannte CD-Roms. Der Begriff Datenshredder im Sinne dieser Anmeldung umfasst also nicht nur Dokumentenvernichter sondern auch entsprechend angepasste Vernichter von Datenträgern.

Bei solchen Dokumentenvernichtern ist es für eine betriebssichere Funktionsweise erforderlich, daß die Lichtschranke einerseits nur dann als unterbrochen gilt, wenn tatsächlich ein Gegenstand zwischen dem Signalgeber der Lichtschranken und dem Signalempfänger der Lichtschranke in den Einlaufschacht eingeführt wurde und somit der Signalübertragungsweg von Signalgeber zu Signalempfänger unterbrochen wurde. Es ist zu vermeiden, daß - beispielsweise durch vorhandenes Streulicht - der Signalpegel am Signalempfänger so hoch bleibt, daß nicht erkannt wird, daß Schneidgut im Bereich des Einlaufschachtes den Signalweg vom Signalgeber zum Signalempfänger unterbrochen hat. Dabei ist dies auch dann sicherzustellen, wenn aufgrund schlechter Aufstellbedingungen des Datenshredders, beispielsweise im Einfallsbereich direkten Sonnenlichts, eine hohe Strahlungsintensität im Streulichtbereich gegeben ist. Andererseits muß auch sichergestellt sein, daß das von dem Signalgeber ausgesendete Signal stets ausreichend groß ist, daß bei ununterbrochener Signalstrecke nicht auf eine Unterbrechung der Signalstrecke geschlossen wird und eine unbeabsichtigte Inbetriebnahme des Schneidwerks unterbleibt.

Diese beiden Aufgaben können in einfacher Weise dadurch gelöst werden, daß seitens des Signalgebers eine hohe Signalintensität ausgestrahlt wird und der Signalempfänger, bzw. die nachgeordnete Auswerteschaltung einen hohen Schwellenwert für die Schaltschwelle der empfangenen Signalintensität aufweist. Diese Maßnahme wurde bei üblichen Datenshreddern auch vorgenommen.

Dabei ist es bei derartigen Datenshreddern nachteilig, wenn der Signalgeber mit hoher Intensität ausstrahlt. Je größer die Strahlungsintensität des Signalgebers ist, desto größer ist auch seine Leistungsaufnahme. Im üblichen Betrieb eines Datenshredders befindet dieser sich im betriebsbereiten Zustand, in dem die Lichtschranke arbeitet, der Signalweg aber nicht unterbrochen ist und daher das Schneidwerk außer Betrieb ist. Die Zeit, während der Antrieb das Schneidwerk tatsächlich antreibt und die Leistungsaufnahme des Datenshredders durch die elektrische Leistungsaufnahme des Antriebs bestimmt wird, ist sehr gering. Dies beruht auf der Tatsache, daß zwar immer wieder Schneidgut zugeführt wird, jedoch zwischen der Zufuhr von Schneidgut jeweils längere Pausen eintreten. Dadurch ergibt es sich, daß ein erheblicher, wenn nicht sogar überwiegender Teil des Stromverbrauches über einen Arbeitstag hinweg nicht durch die Leistungsaufnahme des elektrischen Antriebs, sondern durch die Leistungsaufnahme der Lichtschranke bestimmt wird.

Aufgabe der Erfindung ist es daher, bei gleichzeitiger Erhöhung der Betriebssicherheit, den Energieverbauch eines Datenshredders zu reduzieren.

Die erfindungsgemäße Aufgabe wird bei Zugrundelegen des gattungsgemäßen Datenshredders erfindungsgemäß durch die kennzeichnenden Merkmale der unabhängigen Patentansprüche gelöst.

Ein Datenshredder weist einen elektrischen Antrieb auf, der ein Schneidwerk antreibt. Es ist ein Einlaufschacht ausgebildet, der der Zufuhr von Schneidgut zum Schneidwerk dient. Im Bereich des Einlaufschachtes ist ein Signalgeber angeordnet und ein Signalempfänger. Zwischen Signalgeber und Signalempfänger erstreckt sich die signalstrecke über die ein vom Signalgeber ausgesendetes Signal zum Signalempfänger gelangt, wobei die Signalstrecke durch den Einlaufschacht verläuft. Die Signalstrecke wird dann unterbrochen, wenn Schneidgut durch den Einlaufschacht dem Schneidwerk zugeführt wird. Die vom Signalempfänger empfangenen Signale werden in einer Auswerteschaltung verarbeitet, ein Einschalten des elektrischen Antriebs des Schneidwerks erfolgt dann, wenn die Signalstrecke zwischen Signalgeber und Signalempfänger als durch Schneidgut unterbrochen gilt. Gemäß der Erfindung ist eine Ansteuerschaltung für den Signalgeber vorgesehen, wobei durch den Signalgeber ein gepulstes Aussenden von Signalen erfolgt.

Gemäß einer vorteilhaften Ausgestaltung der Erfindung erfolgt das Aussenden der Signale periodisch gepulst durch den Signalgeber. Dabei ist das Verhältnis zwischen Signaldauer und Periodendauer vorteilhafterweise höchstens gleich 0,2 und liegt vorzugsweise zwischen 0,05 und 0,01. Dies bedeutet, daß die Zeitdauer, während der ein Signal tatsächlich ausgesendet wird, höchstens 20% beträgt und vorzugsweise zwischen 5% und 10% der Betriebszeit des Signalgebers liegt. Der Energieverbrauch des Signalgebers reduziert sich entsprechend dem Verhältnis zwischen Signaldauer und Periodendauer der periodisch gepulsten Aussendung von Signalen.

Gemäß bevorzugter Ausgestaltung der Erfindung ist die Auswerteschaltung derart ausgebildet, daß der Signalempfänger lediglich die empfangenen Signale berücksichtigt, die während des Aussendens von Signalen durch den Signalgeber, empfangen werden.

Ebenfalls vorteilhaft ist eine Ausgestaltung der Erfindung, in dem das Signal selbst als eine Anzahl aufeinanderfolgender Impulse ausgebildet ist. In diesem Fall ist also dem relativ niederfrequenten Signalverlauf des Zustandes zwischen Aussendung und Nichtaussendung von Signalen durch den Signalgeber ein höherfrequentes Signal überlagert, so daß während der Aussendung des Signals vorzugsweise ebenfalls ein periodischer Signalverlauf gegeben ist. Die Periodizität dieses Signalverlaufes ist bevorzugt mindestens so, daß wenigstens zwei Perioden innerhalb der Signaldauer gegeben sind. Dabei ist es möglich, daß eine Synchronisation zwischen dem Beginn der Signaldauer des Signals und der überlagerten Schwingung stattfindet.

Weiterhin ist eine vorteilhafte Ausgestaltung der Erfindung darin zu sehen, daß während der Periodendauer und außerhalb der Signaldauer ein Energiespeicher geladen wird, der während der Signaldauer entladen wird. Durch diese Maßnahme kann die Leistungsaufnahme des Signalgebers verstärkt werden und es entsteht nicht eine ständig schwankende Stromaufnahme des Datenshredders. Es können so auch Leistungsspitzen in der Leistungsaufnahme ermöglicht werden und während der Signaldauer kurzzeitig Signale hoher Intensität erzeugt werden, ohne daß sämtliche Bauteile auf diese hohe Leistungsaufnahme auszurichten sind.

Ebenfalls vorteilhaft ist eine Ausgestaltung der Erfindung, gemäß der der Signalpegel, der vom Signalempfänger in der Periodendauer und außerhalb der Signaldauer empfangen wird zur Bestimmung des erforderlichen Signalpegels des Signalgebers und der Empfindlichkeit des Signalempfängers herangezogen wird. Es ist insbesondere vorteilhaft, eine Steuerung oder Regelung des Signalpegels des Signalgebers und vorzugsweise auch der Empfindlichkeit des Signalempfängers in Abhängigkeit des außerhalb der Signaldauer empfangenen Signalpegels am Signalempfänger vorzunehmen.

Vorteilhafterweise emittiert der Signalgeber im infraroten oder im sichtbaren Bereich und ist vorteilhafterweise als Leuchtdiode ausgebildet. Der Signalempfänger ist vorzugsweise ein im entsprechenden Spektralbereich arbeitender Phototransistor.

Eine vorteilhafte Schaltungsanordnung für die Erfindung sieht einen Impulsgeber vor, wobei der Impulsgeber zumindest das Aussenden von Signalen und vorzugsweise auch das Auswerten der empfangenen Signale bestimmt.

Eine entsprechende Schaltungsanordnung weist vorteilhafterweise einen vorzugsweise als Phototransistor ausgebildeten Signalempfänger auf. Diesem ist gemäß vorteilhafter Ausgestaltung ein invertierender Impedanzwandler, insbesondere ein Verstärker nachgeschaltet. Gemäß einer derartigen Ausgestaltung der Erfindung ist es vorteilhaft, wenn während der Signaldauer mittels des Impedanzwandlers ein Energiespeicher, wie z.B. ein Kondensator, aufgeladen wird und sich mit einem Entladestrom zwischen zwei aufeinanderfolgenden Signalen entlädt. Gemäß einer vorteilhaften Weiterbildung ist der Energiespeicher Teil eines RC-Kreises, und diesem RC-Kreis ist ein Schwellwertschalter zugeordnet. Durch den Schwellwertschalter erfolgt ein Einschalten des elektrischen Antriebs des Schneidwerks dann, wenn der Ladungszustand des Energiespeichers einen Schwellwert unterschreitet. Gemäß bevorzugter Ausgestaltung wird der Betrieb des Antriebs für das Schneidwerk so lange fortgesetzt, wie der Schwellwert unterschritten ist.

Gemäß einer vorteilhaften Ausgestaltung der Erfindung ist ein Komparator vorgesehen, wobei im Komparator die Impulsfolge des Impulsgebers und die Impulsfolge des Signalempfängers zugeführt werden. Sobald im Komparator festgestellt wird, daß die beiden Eingangssignale voneinander abweichen, erfolgt die Inbetriebnahme des Antriebmotors des Schneidwerks.

Gemäß einer weiteren vorteilhaften Ausgestaltung der Erfindung ist es auch möglich, daß eine Regeleinrichtung vorgesehen ist, die die Intensität des Signals des Signalgebers und die Meßempfindlichkeit des Signalempfängers bestimmt. Diese Regeleinrichtung bestimmt die Signalintensität und die Meßempfindlichkeit des Signalempfängers vorzugsweise in Abhängigkeit des zwischen zwei Signalen empfangenen Signalpegels des Signalempfängers. Hierzu sind insbesondere zwei miteinander verbundene Transistoren als Regeleinrichtung vorgesehen.

Die vorstehenden und weiteren Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird.

Im übrigen ist die Erfindung auch anhand der in der Zeichnung dargestellten Ausführungsbeispiele näher erläutert; dabei zeigt:
- Fig.1:: einen beispielhaft dargestellten Signalverlauf des vom Signalgeber aus gesendeten periodisch getakteten Signals;
- Fig. 2:: ein erstes Beispiel für eine Schaltungsanordnung;
- Fig. 3:: ein zweites Ausführungsbeispiel für eine Schaltungsanordnung;
- Fig. 4:: ein drittes Ausführungsbeispiel für eine Schaltungsanordnung;
- Fig. 5:: die Darstellung eines getakteten Signals, wobei das Signal an sich eine Folge von Impulsen ist;
- Fig. 6:: eine Schaltungsanordnung, bei der die Intensität des ausgesendeten Signals in Abhängigkeit des vom Signalempfängers empfangenen Signals geregelt ist und
- Fig. 7:: die schematische Darstellung eines erfindungsgemäßen Datenshredders.

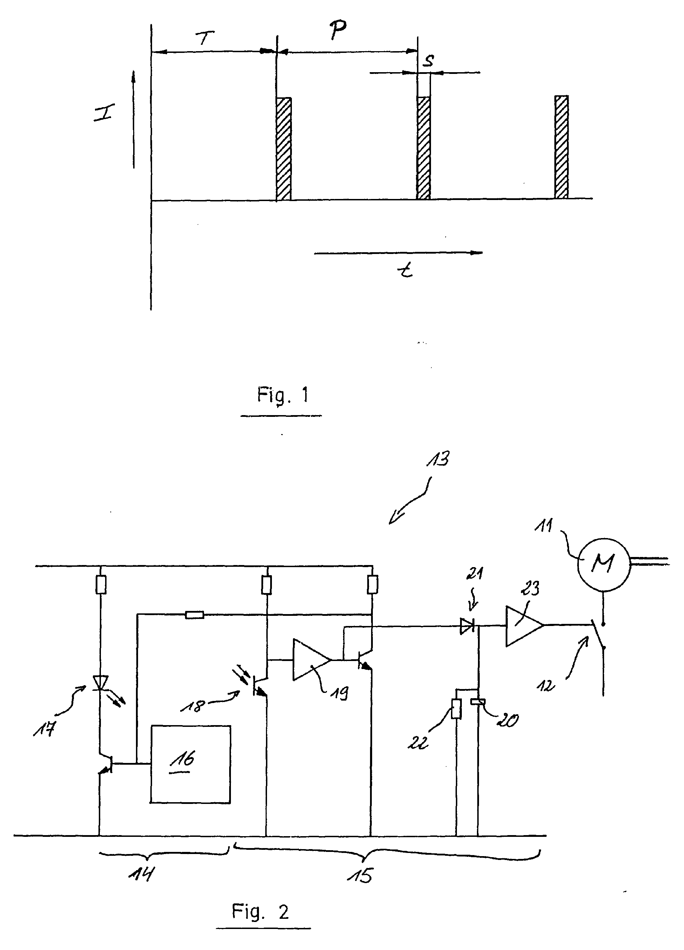

Die Fig. 1 zeigt den Signalverlauf eines von dem Signalgeber gemäß der Erfindung gepulst ausgesendeten Signals. Das Signal ist durch die Periodendauer P gekennzeichnet. Innerhalb der Periode ist eine signalfreie Totzeit T und eine Signaldauer S gegeben. Während der Signaldauer S beträgt die Signalintensität einen vorgegebenen Wert, wogegen während der Totzeit T kein Signal vom Signalgeber ausgesendet wird. Die Summe von Signaldauer und Totzeit ergeben die Periodendauer. Eine wesentliche Charakteristik des Signals ist das Verhältnis zwischen Signaldauer S und Periodendauer P. Es ist insbesondere von Vorteil, wenn das Verhältnis von S zu P höchstens gleich 0,2 ist und vorzugsweise zwischen 0,05 und 0,1 liegt. Dies bedeutet, daß die Signaldauer höchstens 20% der Periodendauer beträgt. Nur in dieser Zeit verbraucht der Signalgeber die hohe Energiemenge, die er zum Aussenden eines Signals benötigt. Während der Totzeit wird zwar von der Schaltungselektronik Energie verbraucht, diese ist jedoch wesentlich geringer wie die Leistungsaufnahme des Signalgebers. Der Signalgeber ist also mindestens zu 80% in einem quasi ausgeschaltetem Zustand und verbraucht daher nahezu keine oder wenig Energie. Hierdurch wird die erfindungsgemäße Energieeinsparung ermöglicht. Gleichzeitig wird durch das gepulste Signal eine geringere Streulichtempfindlichkeit erzielt und damit die Betriebssicherheit erhöht. Schematisch dargestellt ist in Fig. 1 die über die Zeit t hinweg aufgetragene Strahlungsintentsität I des Signalgebers.

In der Fig. 2 ist ein erstes Ausführungsbeispiel für eine Schaltungsanordnung gemäß der Erfindung dargestellt. Der elektrische Antrieb 11 für das Schneidwerk wird über den Schalter 12 angesteuert. Wenn die Steuerungselektronik 13 den Schalter 12 schließt, erfolgt die Inbetriebnahme des Antriebs 11, einem elektrischen Motor, während ein Unterbrechen des Schalters 12 die Außerbetriebnahme des Antriebs 11 bewirkt.

Zu diesem Zweck beinhaltet die Steuerungselektronik 13 sowohl eine Ansteuerschaltung 14 als auch eine Auswerteschaltung 15. Die Ansteuerschaltung weist einen Impulsgeber 16 sowie den Signalgeber, die LED 17 auf. Über den Impulsgeber 16 wird das Aussenden des Signals sowie die Signalform des Signalgebers, also im wesentlichen die Signaldauer S sowie die Periodendauer P festgelegt.

Zusätzlich hierzu wird das Signal des Impulsgebers 16 auch der Auswerteschaltung 15 zugeführt, damit das Signal, daß von dem Signalempfänger, der Photodiode 18, empfangen wird, der Signaldauer zugeordnet werden kann und von anderen Signalen, die im wesentlichen aus Streulicht bestehen, getrennt werden.

Der Signalempfänger, der Phototransistor, ist dabei so angeordnet, daß das Signal des Signalgebers, der LED 17, empfangen wird und gleichzeitig möglichst wenig Streulicht empfangen kann. Gleichzeitig sind aber Signalgeber und Signalempfänger so angeordnet, daß die zwischen ihnen liegende Signalstrecke vom Schneidgut unterbrochen wird, wenn dieses in den Einlaufschacht eingeführt wird.

Zur Auswertung des von der Photodiode 18 empfangenen Signals dient der erste Verstärker 19, der ein invertierender Impedanzwandler ist. Im leitenden Zustand der Photodiode 18, also wenn Licht geeigneteIntensität zur Photodiode 18 gelangt, wird der Kondensator 20 über die Diode 21 geladen. Während der Totzeit entlädt sich der Kondensator 20 über den Widerstand 22 und den Operationsverstärker 23. Der Operationsverstärker 23 ist dabei als Schwellwertschalter geschaltet. Dabei ist die Elektronik so aufeinander abgestimmt, daß in der Totzeit die Ladung von dem Kondensator 20 nicht so weit absinkt, daß der Schwellwertschalter 23 anspringt. Solange in jeder Periode P von dem Signalempfänger das Signal der Signaldauer S empfangen wird, erfolgt kein Schaltvorgang des Schwellwertschalters 23. Wird jedoch durch Papier oder durch anderes Schneidgut, wie z.B. CDs, andere Datenträger und dergleichen, unterbrochen, so fällt die Ladung des Kondensators 20 soweit, daß die Schaltschwelle des Schwellwertschalters 23 unterschritten wird. Hierdurch wird der Schalter 12 geschlossen und der Antrieb 11 des Schneidwerks in Betrieb genommen. Sobald die Signalstrecke zwischen Signalgeber 17 und Signalempfänger 18 nicht mehr unterbrochen ist, wird, zumindest nach einigen wenigen Periodendauern P, der Kondensator 20 wieder soweit aufgeladen, daß die Schaltschwelle des Schwellwertschalters 23 wieder überschritten wird. Über die Periodendauer P sowie über die Anzahl der erforderlichen Periodendauern P um den Kondensator 20 wieder so zu laden, daß der Schwellwert des Schwellwertschalters 23 wieder überschritten wird, wird dabei in einfacher Weise gleichzeitig ein Nachlauf für den Antrieb 11 erzeugt.

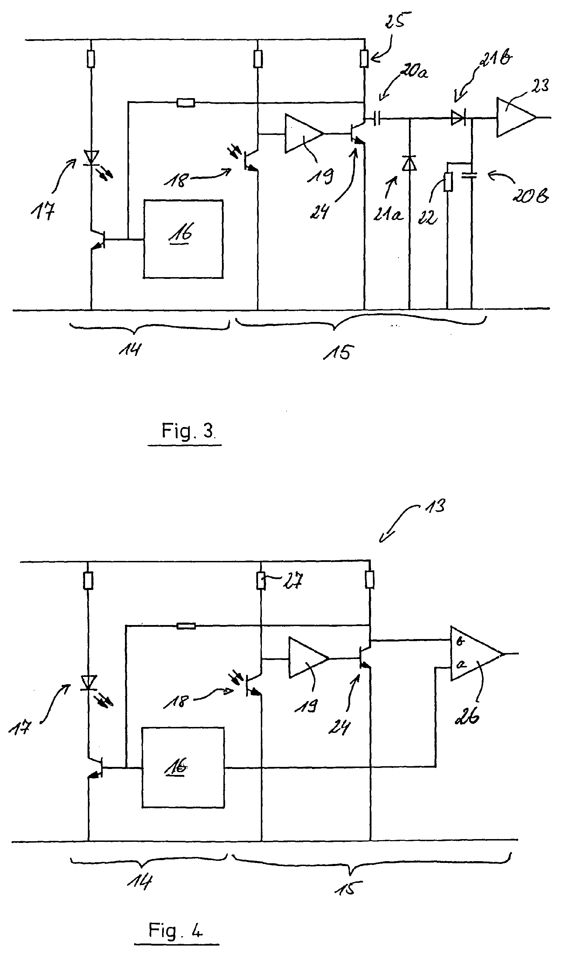

Die Fig. 3 zeigt ein zweites Ausführungsbeispiel der Erfindung. Hierbei wurde auf die Darstellung des Schalters 12 und des Antriebs 11 verzichtet. Ansonsten wurden, soweit Übereinstimmungen bestehen, die gleichen Bezugszeichen, wie in der Fig. 2 gewählt. Das Ausführungsbeispiel gemäß der Fig. 3 unterscheidet sich von dem Ausführungsbeispiel gemäß der Fig. 2 dahingehend, daß das Signal des Impulsgebers 16 dazu dient, das von der Photodiode 18 empfangene Signal, das von dem Signalgeber 17 stammt, vom Streulicht zu unterscheiden. Das aufgrund des Impulsgebers 16 von der LED 17 ausgesandte Signal wird von dem Phototransistor 18 empfangen und an einen Impedanzwandler, bestehend aus dem Verstärker 19 und dem Transistor 24 weitergeleitet. Der Phototransistor 18 ist dabei leitend, wenn Licht ausreichender Intensität in ihn einfällt. Im leitenden Zustand des Phototransistors 18 sperrt der Transistor 24 und die Kondensatoren 20a, 20b werden über den verhältnismäßigen niederohmigen Widerstand 25 geladen. Sobald der Phototransistor 18 sperrt, also nicht mehr Licht ausreichender Intensität in ihn einfällt, wird der Transistor 24 leitend. Der Kondensator 20a kann sich nun über die Diode 21a und den Transistor 24 entladen. Die Diode 21b verhindert jedoch ein entladen des Kondensators 20b, da sie sperrend geschaltet ist. Über die kapazitive Kopplung des Kondensators 20a kann nur ein impulsbehaftetes Signal zur Auswertung gelangen.

In der Totzeit entlädt sich der Kondensator 20b über den Widerstand 22 und den nachgeschalteten, als Schwellwertschalter geschalteten Operationsverstärker 23. Wie im Ausführungsbeispiel der Fig. 2 ist es auch hier so, daß die Totzeit T alleine nicht ausreichend ist, um die Ladung des Kondensators 20 soweit absinken zu lassen, daß der Schwellwert des Schwellwertschalters 23 unterschritten wird und dieser somit anspricht. Erst wenn Schneidgut den Signalweg zum Signalempfänger, dem Phototransistor 18, unterbricht, wird die Schaltschwelle des Schwellwertschalters 23 unterschritten und damit der Antrieb des Schneidwerks angetrieben. Sobald der Lichtstrahl nicht mehr unterbrochen ist, kann sich der Kondensator 20b taktweise wieder laden. Die Ladung des Kondensators 20b steigt dann wieder über den Schwellwert des Schwellwertschalters 23 an und der Antrieb wird wieder unterbrochen.

Die Fig. 4 zeigt eine Abwandlung der Schaltungsanordnung gemäß der Fig. 3, deren Vorteil darin liegt, daß nur ein Signal mit einer bestimmten Impulsfolge von der Auswerteeinheit erkannt wird.

Bis zu dem Transistor 24 ist die Schaltungsanordnung der Fig. 4 identisch mit der Schaltungsanordnung der Fig. 3. Der Ausgang des Transistors 24 wird jedoch nicht zu einem Kondensator, sondern zum Eingang b eines Komparators 26 geführt. Auf den anderen Eingang a des Komparators 26 wird der Takt des Impulsgebers 16 geschaltet. Der Komparator 26 vergleicht die über den Phototransistor 18 eingekoppelten Impulse mit den Impulsen des Impulsgebers 16. Wird Material zur Zerkleinerung in den Einlaufschacht des Datenshredders eingeführt, wird der Signalweg zu dem Phototransistor 18 unterbrochen und damit in dem Komparator 26 Signalungleichheit zwischen den Signalen der Eingänge a und b festgestellt. Dadurch wird der Antrieb 11 eingeschaltet. Sobald das Schneidgut den Signalweg nicht mehr unterbricht, gelangen wieder übereinstimmende Signale zu den Eingängen a und b des Komparators 26 und der Antrieb 11 wird gestoppt.

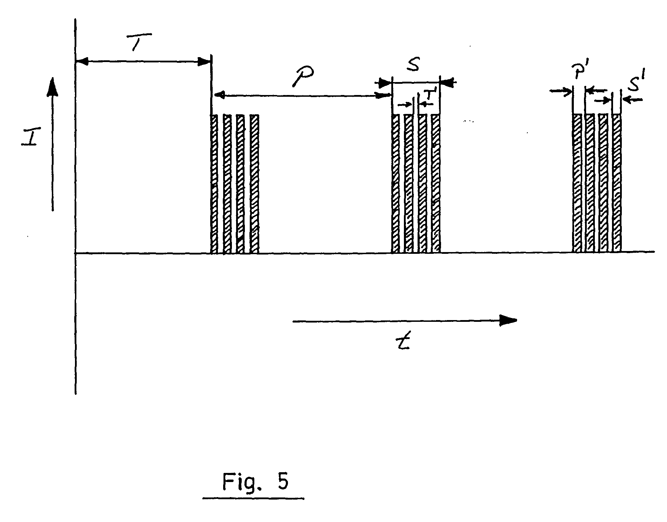

Eine gegenüber dem in der Fig. 1 dargestellten Signalverlauf weiter vorteilhafte Ausgestaltung der Erfindung nutzt einen Signalverlauf, wie er in der Fig. 5 dargestellt ist. Die Periodendauer P ist dabei wiederum in eine Signaldauer S und in eine Totzeit T unterteilt. Hierbei ist die Signaldauer S tendenziell im Verhältnis zur Periodendauer größer gewählt und das Verhältnis liegt eher im Bereich von 0,2 als in dem Bereich zwischen 0,05 und 0,1. Während der Signaldauer S wird nicht ein konstantes Signal, wie in der Fig. 1 dargestellt, abgegeben, sondern eine Folge von Impulsen. Es ist also ein Signal gegeben, daß in sich wiederum zeitweise eine vorgegebene Intensität I und dazwischen eine Pause der Abstrahlung von Licht durch die Leuchtdiode 17 aufweist. In der Signaldauer S ist also dem Signalverlauf der Hüllkurve, wie sie in der Fig. 1 dargestellt ist, ein Signal mit ebenfalls einer Periodizität P , der Signaldauer S und der Todzeit T überlagert. Dabei beträgt die Signaldauer S möglichst ein ganzzahliges, vielfaches der Periodendauer P des überlagerten Signals. Das ganzzahlige Vielfache ist beispielsweise das vier- oder fünffache, mindestens jedoch das zweifache. Durch diese Maßnahme kann die Sensibilität der Schaltungsanordnung gegenüber Fremdlicht weiter reduziert werden und auch der Energieverbrauch und die Leistungsaufnahme der Steuerungselektronik 13 wird weiter reduziert. Das Signal, wie es in der Fig. 5 dargestellt ist, kann beispielsweise in Verbindung mit einer Schaltungsanordnung gemäß der Fig. 4 verwendet werden. Die Auswertung des Signals erfolgt wie in der Fig. 4 dargestellt, in dem Komparator 26. Der Komparator 26 könnte aber auch durch andere digitale Bauelemente, die die Impulspakete an den Eingängen a und b vergleichen, ersetzt werden. Es können dies beispielsweise Zähler oder Schieberegister sein. Wird die Bestromung der Leuchtdiode, dem Signalgeber 17, stark erhöht, beispielsweise auf das fünffache und gleichzeitig der Kolektorwiderstand 27 reduziert, wird die Fremdlichtempfindlichkeit nochmals stark verringert. Die Bestromung der Leuchtdiode LED 17 erfolgt in sehr kurzen Impulsen während der Signaldauer S. Die sehr kurzen Impulse haben also eine in sich gesehen eine sehr geringe Signaldauer S . Die während dieser Signaldauer S benötigte Stromstärke wird beispielsweise mittels eines Glättungskondensators von dem Netzteil oder einem separaten Kondensator bezogen, der sich in der Totzeit T und den kleinen Totzeiten T zwischen den einzelnen Impulsen während der Signaldauer S wieder ausreichend mit Energie auflädt. Trotz der erhöhten Strahlungsintensität des Signalgebers während der überlagerten Signaldauer S ist die gemittelte Leistungsaufnahme jedoch weiterhin geringer, da die Zeit, während der die Leistungsaufnahme stattfindet, weiter deutlich verringert wurde.

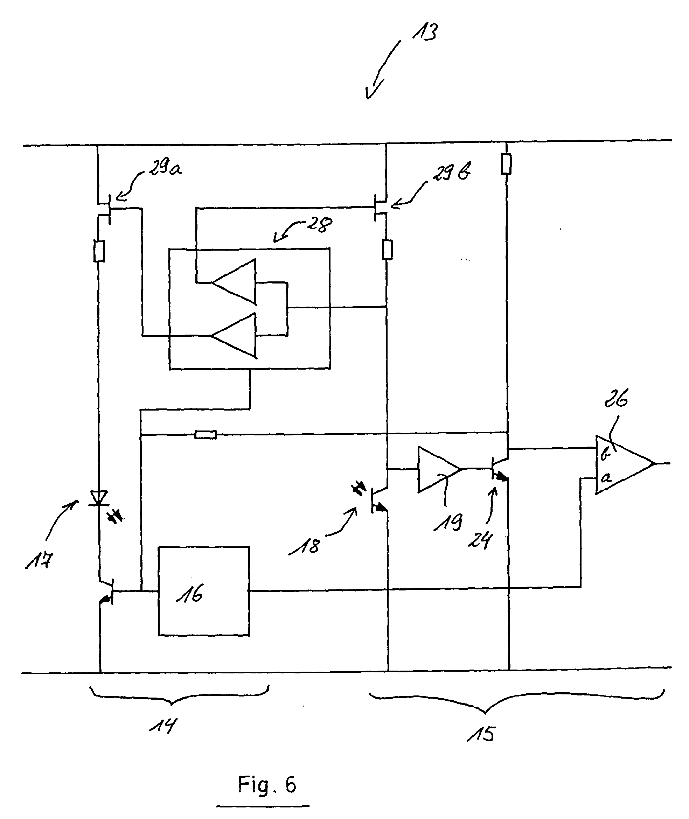

Die Fig. 6 zeigt eine weitere alternative Gestaltung einer erfindungsgemäßen Schaltungsanordnung. Die Besonderheit der Schaltungsanordnung ist darin zu sehen, daß eine Regelung der Empfindlichkeit des Phototransistors 18 sowie der Intensität des ausgesendeten Signal der Leuchtdiode 17 stattfindet.

Die Schaltungsanordnung, wie sie in der Fig. 6 dargestellt ist, entspricht prinzipiell der in Fig. 4 dargestellten Schaltungsanordnung. Es ist darüber hinaus jedoch noch eine Regeleinheit 28 ausgebildet. Insoweitwerden nachfolgend nur noch die Abweichungen hierzu beschrieben. In der Totzeit T wird von der Regeleinheit 28 der von dem Phototransistor 18 empfangene Fremdlichtanteil gemessen und gespeichert. Bei einem hohen Fremdlichtanteil werden die Transistoren 29a und 29b niedrigohmiger. Dadurch wird der Signalgeber, die Leuchtdiode 17, stärker bestromt und die ausgesandte Lichtintensität erhöht. Gleichzeitig benötigt der Signalempfänger, der Phototransistor 18, eine größere Lichtmenge um durchzusteuern. Bei geringem oder kleinem Fremdlichtanteil, wie z.B. nachts oder in dunklen Räumen, werden die Transistoren 29a und 29b hochohmiger geregelt. Damit erfolgt eine Verringerung der von dem Signalgeber 17 ausgesandten Lichtintensität und gleichzeitig eine Erhöhung der Empfindlichkeit des Fototransistors 18. Somit wird durch die Regeleinheit 28 die Fremdlichtempfindlichkeit der Steuerung weiter reduziert und gleichzeitig die Leistungsaufnahme der Schaltungsanordnung verringert.

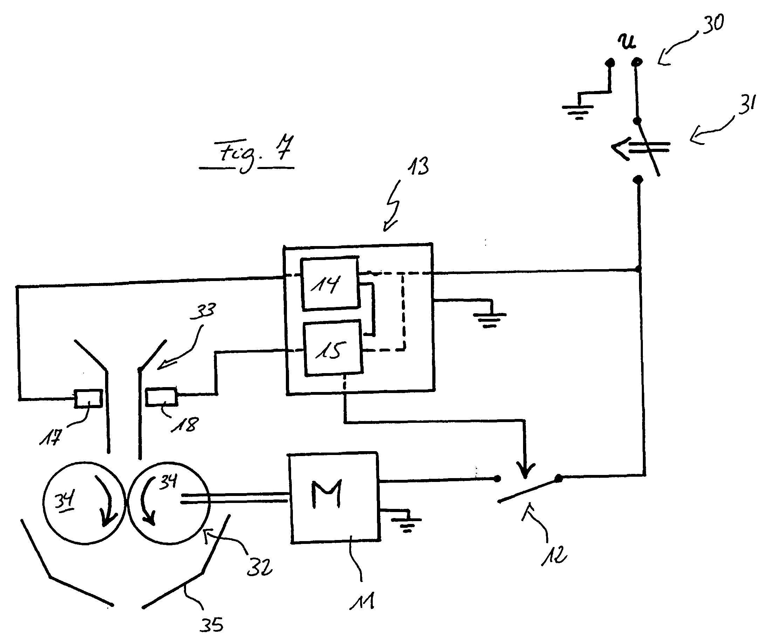

In der Fig. 7 ist in schematischer Darstellung ein Ausführungsbeispiel für einen erfindungsgemäßen Datenshredder dargestellt. Der Datenshredder ist an die Spannungsversorgung 30 angeschlossen. Über den Hauptschalter 31, der manuell betätigbar ist, wird die Betriebsbereitschaft des Datenshredders erzeugt. Wird der Hauptschalter 31 geschlossen, so ist der Datenshredder betriebsbereit, während er in geöffneter Stellung des Hauptschalters 31 nicht betriebsbereit ist. Über die Spannungsversorgung 30 wird sowohl der Antrieb 11 als auch die Steuerungselektronik 13 mit Spannung versorgt. Zur Anpassung der Betriebsspannung von Antrieb 11 und Steuerungselektronik 13 können zwischen diesen Einheiten und der Spannungsversorgung 30 jeweils entsprechende Transformatoren und Wandler, beispielsweise Gleichrichter für die Steuerungselektronik 13, vorgesehen sein. Die Steuerungselektronik 13 besteht aus zwei Untereinheiten, nämlich der Ansteuerschaltung 14 und der Auswerteschaltung 15, die jedoch in einem gemeinsamen Schaltelement verbunden sein können und auch über Signalleitungen miteinander verknüpft sein können. Über die Ansteuerschaltung 14 wird der Signalgeber 17 angesteuert, während in der Auswerteeinheit 15 das von dem Phototransistor, also dem Signalempfänger 18, empfangene Signal ausgewertet wird. In Abhängigkeit der Auswerteschaltung 15 erfolgt eine Betätigung des Schalters 12. Solange aufgrund des von dem Signalempfänger 18 empfangenen Signals in der Auswerteschaltung 15 darauf geschlossen wird, daß die Signalstrecke zwischen dem Signalgeber 17 und dem Signalempfänger 18 nicht unterbrochen ist, bleibt der Schalter 12 geöffnet und damit der Antrieb 11 ausgeschaltet. Sobald der Schalter 12 geschlossen wird, bleibt der Antrieb 11, das Schneidwerk 32 an. Zur Zufuhr von Schneidgut zum Schneidwerk 32 dient der Einlaufschacht 33, wobei vorteilhafterweise Signalgeber 17 und Signalempfänger 18 an je einer Seite des Einlaufschachtes einander gegenüberliegend angeordnet sind. Bei dem Schneidwerk 32 handelt es sich vorzugsweise um zwei Schneidwalzen, durch die ein Streifenschnitt oder ein Partikelschnitt des Schneidgutes erfolgt. Dabei muß dem Schneidwerk 32 nicht zwangsläufig ein Schneidvorgang im eigentlichen Sinne des Wortes durchgeführt werden, es kann auch durch Zerreißen und ähnliche Vorgänge ein Auftrennen des Schneidguts in unterschiedliche Teilstücke, beispielsweise in Streifen oder Partikel, einer vorgebbaren Größe, erfolgen. Die Schneidwalzen 34 des Schneidwerks 32 werden von dem Antrieb 11 angetrieben. Sie zerkleinern das zugeführte Schneidgut, was nach dem Zerkleinern in dem Auslauftrichter 35 aufgefangen und dann in einen Vorratsbehälter oder dergleichen gesammelt wird.

## Patentansprüche

1. Datenshredder, mit einem über einen elektrischen Antrieb angetriebenen Schneidwerk, mit einem Einlaufschacht zur Zufuhr von Schneidgut zum Schneidwerk, mit einem im Bereich des Einlaufschachtes angeordneten Signalgeber und einem im Abstrahlbereich des Signalgebers angeordneten Signalempfängers, wobei mittels einer Auswerteschaltung ein Einschalten des elektrischen Antriebs zumindest dann erfolgt, wenn die Signalstrecke zwischen Signalgeber und Signalempfänger, die im Bereich des Einlaufschachtes ausgebildet ist, als durch Schneidgut unterbrochen gilt, **dadurch gekennzeichnet, daß** eine Ansteuerschaltung (14) für den Signalgeber (17) vorgesehen ist, wobei ein gepulstes Aussenden von Signalen durch den Signalgeber (17) vorgesehen ist.

2. Datenshredder nach Anspruch 1, **dadurch gekennzeichnet, daß** ein periodisch gepulstes Aussenden von Signalen durch den Signalgeber (17) vorgesehen ist.

3. Datenshredder nach Anspruch 2, **dadurch gekennzeichnet, daß** das Verhältnis zwischen Signaldauer (S) und Periodendauer (P) höchstens gleich 0,2 ist und vorzugsweise zwischen 0,05 und 0,1 liegt.

4. Datenshredder nach einem der Ansprüche 2 oder 3, **dadurch gekennzeichnet, daß** das Signal eine Folge einer Anzahl von Impulsen (S∩) ist.

5. Datenshredder nach einem der vorstehenden Ansprüche, **dadurch gekennzeichnet, daß** die Auswerteschaltung (15) derart ausgebildet ist, daß vom Signalempfänger (18) empfangene Signale lediglich dann berücksichtigt werden, wenn sie während der Signaldauer (S) empfangen werden.

6. Datenshredder nach einem der vorstehenden Ansprüche, **dadurch gekennzeichnet, daß** zur Erzeugung des Signals ein Energiespeicher vorgesehen ist, wobei der Energiespeicher während des Aussendens eines Signals entleert und zwischen dem Aussenden von Signalen aufgeladen wird.

7. Datenshredder nach einem der vorstehenden Ansprüche, **dadurch gekennzeichnet, daß** aus dem Signalpegel, der während der Totzeit (T) zwischen zwei Signaldauern (S) am Signalempfänger (18) empfangene Signalpegel zur Bestimmung, insbesondere zur Regelung wenigstens eines der beiden Größen Signalpegel des Signalgebers (17) und Empfindlichkeit des Signalempfängers (18) dient.

8. Datenshredder nach einem der vorstehenden Ansprüche, **dadurch gekennzeichnet, daß** der Signalgeber (17) als im infraroten oder sichtbaren Bereich emittierende Leuchtdiode und der Signalempfänger (18) ein im entsprechenden Spektralbereich arbeitender Phototransistor ausgebildet ist.

9. Schaltungsanordnung mit einer Lichtschranke, insbesondere nach einem der vorstehenden Ansprüche, **dadurch gekennzeichnet, daß** ein Impulsgeber (16) vorgesehen ist, wobei zumindest das Aussenden von Signalen und vorzugsweise auch das Auswerten der empfangenen Signale in Abhängigkeit des Impulsgebers (16) erfolgt.

10. Schaltungsanordnung nach Anspruch 9, **dadurch gekennzeichnet, daß** dem Empfänger (18) insbesondere einem Phototransistor, ein invertierender Impedanzwandler, insbesondere ein Verstärker (19) nachgeschaltet ist, wobei während der Signaldauer (S) mittels des Impedanzwandlers wenigstens ein Energiespeicher, insbesondere ein Kondensator (20, 20a, 20b) geladen und während der Totzeit (T) entladen wird.

11. Schaltungsanordnung nach Anspruch 10, **dadurch gekennzeichnet, daß** dem Energiespeicher, insbesondere der Kondensator (20, 20b) eines RC-Kreises, ein Schwellwertschalter (23) zugeordnet ist, wobei ein Einschalten des elektrischen Antriebs (11) erfolgt, wenn der Ladungszustand des Energiespeichers (20, 20b) den Schwellwert des Schwellwertschalters (23) unterschreitet.

12. Schaltungsanordnung nach Anspruch 11, **dadurch gekennzeichnet, daß** ein Betrieb des elektrischen Antriebs (11) solange erfolgt, bis der Ladungszustand des Energiespeichers (20, 20b) den Schwellwert des Schwellwertschalters (23) wieder übersteigt.

13. Schaltungsanordnung nach Anspruch 9, **dadurch gekennzeichnet, daß** ein Komparator (26) vorgesehen ist, wobei im Komparator (26) das von dem Impulsgeber (16) generiertes Signal von dem Signalempfänger (18) empfangene Signal verglichen wird, und bei einem Abweichen der Signale voneinander auf die Zufuhr von Schneidgut geschlossen wird.

14. Schaltungsanordnung nach einem der Ansprüche 9 bis 13, **dadurch gekennzeichnet, daß** eine Regeleinheit (28) ausgebildet ist, wobei diese insbesondere zwei Transistoren (29a, 29b) ansteuert, wobei mit der Regeleinheit (28) die Intensität des vom Signalgeber (17) abgegebenen Signals und die Eingangsempfindlichkeit des Signalempfängers (18) in Abhängigkeit des vom Signalempfänger (18) während der Todzeit (T) empfangenen Signalpegels bestimmt, insbesondere gesteuert oder geregelt wird.
